Europäisches Patentamt

European Patent Office

Office européen des brevets

(11) Publication number: **0 057 645**
**A1**

## (12) EUROPEAN PATENT APPLICATION

(21) Application number: **82400173.9**

(22) Date of filing: **02.02.82**

(51) Int. Cl.³: **H 01 L 23/00**

| | |
|---|---|
| (30) Priority: **04.02.81 US 231558** | (71) Applicant: **FAIRCHILD CAMERA & INSTRUMENT CORPORATION, 464 Ellis Street, Mountain View California 94042 (US)** |
| (43) Date of publication of application: **11.08.82 Bulletin 82/32** | (72) Inventor: **Davies, Thomas J., 2870 Deeva Court, Gilroy California 95020 (US)** |
| (84) Designated Contracting States: **DE FR GB IT NL** | (74) Representative: **Chareyron, Lucien et al, Schlumberger Limited 42, rue Saint-Dominique, F-75340 Paris Cedex 07 (FR)** |

(54) **Electrically coded identification of integrated circuit devices.**

(57) The identification numbers of an integrated component may be determined by forming, during the manufacturing of the component, open and closed patterns of diode links between the component input and output pins and a positive voltage bus in the circuitry of the component. The cathodes of the diodes are coupled to a positive circuit bus and therefore the identification circuitry is isolated during operation of the functional circuitry. The open and closed pattern of the links are a binary representation of the component identification number which is read out by an ohmmeter or similar current-sensing type of instrument, the negative terminal of which is connected to the positive voltage terminal pin of the integrated circuit component to therefore forward bias the diodes to provide a current path through the closed links in the binary pattern.

-1-

# ELECTRICALLY CODED IDENTIFICATION OF INTEGRATED CIRCUIT DEVICES

BY

THOMAS J. DAVIES, JR.

## FIELD OF THE INVENTION

This invention relates to integrated circuit production techniques and particularly to a method for determining the identification code or type or model number of an integrated circuit semiconductor device through the input and output pins which are connected to the identification code circuitry within the device.

## DESCRIPTION OF THE PRIOR ART

Integrated circuit devices are generally manufactured in very large quantities and often various manufacturing operations are performed in different manufacturing plants or even different geographical areas. For example, the actual circuitry of the device, excluding the molded outer housing, may be manufactured in one state or country and then shipped to another location for installation of the housing, the printing of the manufacturer's identification, circuit type or model number on the housing, and then perhaps the device will be subsequently shipped to a third location for quality assurance testing, packaging and distribution.

On some occasions, the quality testing facilities receive large quantities of unprinted

devices and being unable to determine the type or even the original manufacturing source of the device, are compelled to either destroy the entire unlabeled shipment or sell it into the surplus market. Also, in other instances, the testing facilities have found that none of the labeled and identified devices in a large shipment of semiconductors would pass the prescribed tests, thus indicating the printing of incorrect identifying numbers. Further, even if the device is correctly labeled with the proper identifying number, excessive handling by the end user or a customer's assembly personnel may wear off the identificaton number or render it illegible. In any of the above instances, the results are the same: the integrated circuit device is useless and must be destroyed or sold for scrap.

It is therefore apparent that there must be some accurate and permanent means of identification of an integrated circuit device irrespective of the identification code printing on the device housing or the lack of such printing.

## SUMMARY OF THE INVENTION

Briefly described one aspect of the invention comprises a method for the electrical identification of a semiconductor device having a plurality of input and output pins coupled to integrated circuitry within the device, the method comprising the steps of: a method for electrically identifying a semiconductor device having a plurality of input and output pins coupled to the integrated circuitry of the device, said method being comprising the steps of: forming within the semiconductor device, during its manufacture, a selected plurality of diode links interconnecting a corresponding plurality of selected input and output pins with a common voltage bus within said device and coupled to a voltage input pin on said device, said diodes being coupled to said positive voltage bus so that they are reverse-biased during normal circuit operation, said diode links being selected in a pattern representing a binary number corresponding to the code number identifying the semiconductor device; and

reading said binary number by applying a first voltage level to said voltage input pin and applying to each of said plurality of input and output pins a second voltage level which exceeds said first level by an amount greater than the threshold voltage of said diodes, and by sensing current flow through said diode links and the absence of current flow through those input and output pins not associated with said diode links

## BRIEF DESCRIPTION OF THE DRAWINGS

In the drawings which illustrate a preferred embodiment of the invention:

FIG. 1 is a perspective drawing of a typical integrated circuit device;

FIG. 2 is a schematic diagram illustrating a sequence of input and output pins selectively connected through diode links representing a binary number; and

FIG. 3 is a schematic diagram of a typical diode link of a metal oxide semiconductor device.

## DESCRIPTION OF THE PREFERRED EMBODIMENT

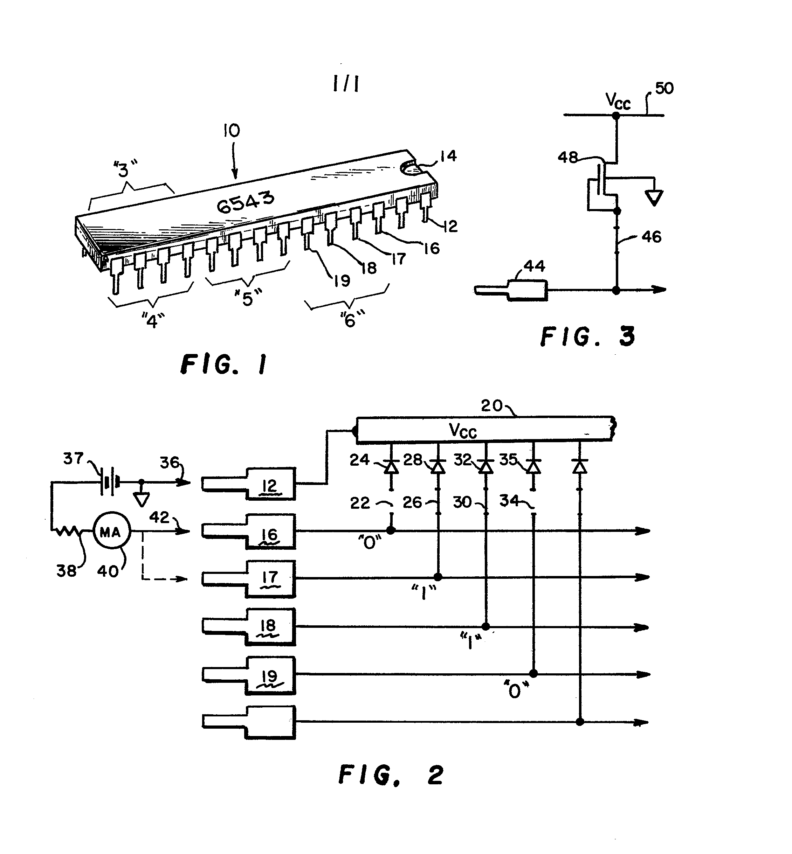

FIG. 1 is an illustration of a typical integrated circuit device 10 such as a microcomputer, a shift register, or the like, and having twenty-eight input or output pins connected to the internal circuitry of the device. One pin 12, which in some devices is the first pin to the right of the alignment code notch 14 indented in one end of the top surface, is for the connection to an external positive voltage source and is internally coupled to the circuitry voltage bus, such as the $V_{cc}$ bus in field effect devices.

-5-

The semiconductor device 10 is illustrated in FIG. 1 with an arbitrary identification number "6543" printed on the top surface of the device housing. This number is applied during manufacture to identify the device as, for example, a particular microprocessor, a random access memory, or a read-only memory, or the like. This printed identification number heretofore has been essential not only for use by the purchaser or end user of the device but also needed by personnel at the manufacturer's quality testing facilities who are charged with the functional testing of the circuitry prior to its being sold or distributed. Without such a printed identification number, the proper quality tests could not heretofore be performed and all unidentified or misidentified devices would necessarily be scrapped.

During manufacture of the integrated circuitry in a semiconductor device, it is a simple and inexpensive masking operation to incorporate coding circuitry that is readable from the device input and output pins and which represents, in binary form, the device identification number that is to be subsequently printed on the top surface of the housing of the device. The particular binary coding system that is employed is, of course, at the discretion of the manufacturer. In smaller devices having relatively few input and output pins it may be desirable to use a binary code whereas in larger devices, such as the twenty-eight pin semiconductor devices of FIG. 10, a hexadecimal numbering system may be preferable. Thus, as shown in FIG. 1, the pins 16, 17, 18, and 19 may be internally coded so that, when read in the manner to be subsequently described, the result represents the first number "6" in the identification number. Similarly, the next group of four pins would be encoded to represent the second number "5", the third group of four pins would be read out as the number "4", and the first group of four pins on the opposite side of the device 10 would represent the last number "3". In a twenty-eight pin device such as device 10, the two unused groups of four pins each would provide two additional digits if required. Therefore, if the identification number on the top surface of the device 10 is missing, incorrect, or becomes illegible, the readout of the input and output pins in the manner to be described hereinafter will provide a proper identification of the device.

FIG. 2 is a schematic diagram illustrating the circuitry that is added to the circuitry of the integrated circuit device to provide the proper identifying code. In the preferred embodiment, each of the input and output pins to be used in determining the identification code is connected to the positive voltage bus 20 through a diode which is in series with a programmable link which may be opened or closed as necessary to provide the necessary continuity of current from the associated input-output pin to the positive voltage bus. Thus, in FIG. 2, the input-output pin 16, which is coupled into the integrated circuitry of the device, is also connected through an open link 22 which obviously prevents any flow of current through the associated diode 24, the cathode of which is connected to the positive voltage bus 20. The input or output pin 17 is coupled to the functional integrated circuitry of the device and also through the programmable link 26 to the anode of diode 28, the cathode of which is connected to the positive voltage bus 20. Pin 18 can also conduct current from the pin through the programmable link 30 and diode, whereas the pin 19 is connected through an opened link 34 to its diode 35. The program link provided by the opened links 22 and 34 and the closed links 26 and 30 represent the binary number "0110", or the first number "6" of the identification.

It is to be noted that the cathode elements of all diodes in the identification code circuitry, such as the diodes 24, 28, 32 and 35 of FIG. 2, are connected to the positive voltage bus 20 and are thus reversed biased so that the code identification circuitry is isolated from the remainder of the integrated circuit during normal operation of the circuitry.

The coded identification circuitry is read by applying a negative terminal 36 of a D.C. voltage source 37 to the normally positive input bus pin 12 and by applying the positive terminal 42 of the source 36 through an appropriate current limiting resistor 38 and through a milliammeter 40 to each of the remaining input and output pins of the device. Thus, as shown in FIG. 2, a negative voltage at circuit ground reference is applied to the normally positive input pin 12 and to the positive bus 20 of the circuitry. A positive potential greater than the threshold voltage level of the diodes 24, 28, 32 and 35 is applied to the pin 16; however, since the programmable link is open, there will be no current flow and no reading on the meter 40. The positive readout terminal 42 is then applied to the pin 17 and the resulting current through the programmable link 26 and diode 28 is sensed by the meter 40. Each succeeding pin is read in a similar manner so that the entire identification code may be determined. It is apparent that the readout circuitry including the potential source 37 and a current sensor, such as the meter 40, may be constructed into a large testing instrument which will simultaneously sense current through all of the input and output pins to provide a rapid readout of the identification code number.

FIG. 3 is a schematic diagram illustrating field effect transistor circuitry associated with one input or output pin 44. The pin 44, in addition to

- 8 -

being connected to the functional circuitry of the field effect semiconductor device, is also coupled through a programmable link 46 to a resistor-connected enhancement mode field effect transistor 48, the source element of which is connected to the normally positive $V_{CC}$ bus 50, and the substrate of which is at circuit ground reference. The gate element of the transistor 48 is coupled to its drain element and to the programmable link 46 so that the transistor 48 functions as a diode in a manner similar to that explained in connection with FIG. 2.

The circuits of FIGS. 2 and 3 may be constructed, if desired, by elimination of the diode elements instead of the opening of a programmable link. Construction of a circuit with a pattern of both diodes and the absence of certain diodes requires the use of two or three masks. In the preferred embodiment, therefore, the diode elements in the form of either diodes such as illustrated in FIG. 2 or enhancement transistors as illustrated in FIG. 3 are formed in the circuitry to link the positive voltage bus with each of the input and output pins, and the formation of the open or closed links are readily programmed by the use of only one mask, thereby effecting a production cost saving.

WHAT IS CLAIMED IS:

1. A method for electrically identifying a semiconductor device having a plurality of input and output pins coupled to the integrated circuitry of the device, said method being characterized by the steps of: forming with the semiconductor device, during its manufacture, a selected plurality of diode links interconnecting a corresponding plurality of selected input and output pins with a common voltage bus within said device and coupled to a voltage input pin on said device, said diodes being coupled to said positive voltage bus so that they are reverse-biased during normal circuit operation, said diode links being selected in a pattern representing a binary number corresponding to the code number identifying the semiconductor device; and reading said binary number by applying a first voltage level to said voltage input pin and applying to each of said plurality of input and output pins a second voltage level which exceeds said first level by an amount greater than the threshold voltage of said diodes, and by sensing current flow through said diode links and the absence of current flow through those input and output pins not associated with said diode links

2. The method of Claim 1 characterized in that said voltage bus is the positive voltage bus of the device, the cathodes of said diodes are coupled to said bus and in that said second voltage level is more positive than said first voltage level.

3. The method of Claim 1 or 2 characterized in that said forming step includes the steps of depositing a plurality of diodes corresponding to the number of input and output pins needed to identify said semiconductor device, and forming a pattern of open and closed circuit conductors linking each diode to its corresponding input and output pin.

4. The method of Claim 2 characterized in that said diodes are enhancement mode field effect transistors, each having its gate electrode coupled to its drain electrode, the source electrode of each transistor being coupled to said positive voltage source.

5. The method of Claim 4 characterized in that the substrate of said field effect transistors are at circuit ground reference.

0057645

1/1

FIG. 1

FIG. 3

FIG. 2

**European Patent Office**

**EUROPEAN SEARCH REPORT**

EP 82 40 0173.9

| DOCUMENTS CONSIDERED TO BE RELEVANT | | | CLASSIFICATION OF THE APPLICATION (Int. Cl. 3) |
|---|---|---|---|
| Category | Citation of document with indication, where appropriate, of relevant passages | Relevant to claim | |
| A | US - A - 4 055 802 (PANOUSIS et al.) <br> * column 2, line 65 to column 4, line 11; column 5, lines 7 to 57 * <br> ---- | 1 | H 01 L 23/00 |

**TECHNICAL FIELDS SEARCHED (Int.Cl. 3)**

B 07 C 5/02
B 07 C 5/34
B 07 C 5/36
B 65 B 61/26.
H 01 L 21/66
H 01 L 23/00

**CATEGORY OF CITED DOCUMENTS**

X: particularly relevant if taken alone
Y: particularly relevant if combined with another document of the same category
A: technological background
O: non-written disclosure
P: intermediate document
T: theory or principle underlying the invention
E: earlier patent document, but published on. or after the filing date
D: document cited in the application
L: document cited for other reasons

&: member of the same patent family, corresponding document

The present search report has been drawn up for all claims

| Place of search | Date of completion of the search | Examiner |
|---|---|---|
| Berlin | 29-04-1982 | GIBBS |

EPO Form 1503.1  08.78